# EUROPEAN PATENT APPLICATION

(11) **EP 4 474 844 A1**
(43) Date of publication of application: **11.12.2024**
(21) Application number: 22923927.2
(22) Date of filing: 31.01.2022
(51) Int. Cl.: G01R 33/02, G01R 33/06

(54) **MAGNETIC SENSOR**

(71) Applicant: TDK Corporation, Tokyo 103-6128 (JP)
(72) Inventor: YAMAJI, Yuichiro, Tokyo 103-6128 (JP); HARAKAWA, Osamu, Binan, Laguna (PH)
(74) Representative: Epping - Hermann - Fischer
(86) International application number: PCT/JP2022/003579
(87) International publication number: WO 2023/145064

(57) **Abstract**

To prevent, in a magnetic sensor provided with an external magnetic body for collecting magnetic flux in a magnetism detection element, breakage of the external magnetic body. A magnetic sensor 100 includes: a sensor chip 20 having an element formation surface 21 on which magnetism detection elements R1 to R4 are formed, an external magnetic body 30 having an end face 33 positioned at the leading end of the longitudinal direction thereof and facing the element formation surface 21 and side surfaces 34 to 36 constituting the outer peripheral surface of the cross section thereof perpendicular to the longitudinal direction, and a protective resin 4 at least partially covering the element formation surface 21 and the side surfaces 34 to 36 of the external magnetic body 30. This makes it possible to prevent breakage of the sensor chip 20 and external magnetic body 30 upon application of an external shock.

## Description

### [Technical Field]

The present invention relates to a magnetic sensor and, more particularly, to a magnetic sensor provided with an external magnetic body for collecting magnetic flux in a magnetism detection element.

### [Background Art]

Patent Document 1 discloses a magnetic sensor provided with an external magnetic body for collecting magnetic flux in a magnetism detection element. More specifically, the magnetic sensor described in Patent Document 1 is provided with a sensor chip having an element formation surface on which a magnetism detection element is provided and an external magnetic body disposed so as to face the element formation surface. With this configuration, a magnetic field collected by the external magnetic body is applied to the magnetism detection element efficiently.

### [Citation List]

### [Patent Document]

[Patent Document 1] International Publication WO 2021/100252

### [Disclosure of the Invention]

### [Problem to be Solved by the Invention]

However, the external magnetic body is often made of a brittle material, such as ferrite, and the sensor chip could be made of a fragile material, such as silicon, so that they are likely to be broken when being applied with an external shock.

It is therefore an object of the present invention to prevent, in a magnetic sensor provided with an external magnetic body for collecting magnetic flux in a magnetism detection element, breakage of the sensor chip and external magnetic body.

### [Means for Solving the Problem]

A magnetic sensor according to the present invention includes: a sensor chip having an element formation surface on which a magnetism detection element is formed; a first external magnetic body having an end face positioned at the leading end in the longitudinal direction thereof and facing the element formation surface and a plurality of side surfaces constituting the outer peripheral surface of the cross section thereof perpendicular to the longitudinal direction; and a protective resin covering at least partially the element formation surface and the plurality of side surfaces of the first external magnetic body.

According to the present invention, the element formation surface of the sensor chip and the plurality of side surfaces of the first external magnetic body are covered with the protective resin, so that it is possible to protect the sensor chip and the first external magnetic body positioned in proximity thereto which are likely to be broken upon application of an external shock.

The magnetic sensor according to the present invention may further include a substrate mounting thereon the sensor chip and first external magnetic body. The sensor chip may be mounted on the substrate such that the element formation surface thereof is substantially perpendicular to the substrate surface. The plurality of side surfaces of the first external magnetic body may include a first side surface facing the substrate, a second side surface positioned on the side opposite the first side surface, and third and fourth side surfaces positioned opposite to each other and connecting the first and second side surfaces. The protective resin may cover at least partially the element formation surface and second to fourth side surfaces. This can alleviate a shock which is applied to the sensor chip and first external magnetic body through the substrate.

The magnetic sensor according to the present invention may further include a second external magnetic body having a bar-like part facing the back surface of the sensor chip positioned on the side opposite the element formation surface, and the protective resin may further be provided between the back surface of the sensor chip and the bar-like part of the second external magnetic body. With this configuration, magnetism collecting effect is enhanced by the presence of the second external magnetic body, and the breakage of the second external magnetic body due to an external shock can be prevented.

The magnetic sensor according to the present invention may further include an auxiliary chip stuck to the back surface of the sensor chip, and the protective resin may be provided between the auxiliary chip and the bar-like part of the second external magnetic body. This can enhance mechanical strength of the sensor chip.

In the present invention, the second external magnetic body may further include an overhang part protruding from the bar-like part toward the element formation surface and bent so as to cover a part of the element formation surface, and the protective resin may further cover the overhang part. This can prevent breakage of the overhang part due to an external shock.

The magnetic sensor according to the present invention may further include a molded member fixed to the first external magnetic body, a compensation coil, and first and second connection pins. The molded member may include a bobbin and a retaining part which house therein the first external magnetic body. The retaining part may be positioned between the sensor chip and the bobbin, the compensation coil may be wound around the bobbin, the first and second connection pins may be fixed to the retaining part, one end and the other end of the compensation coil may be connected respectively to the first and second connection pins, and the protective resin may be embedded between the retaining part and the overhang part. This can prevent more effectively breakage of the overhang part due to an external shock and allows the compensation coil to be wound around the first external magnetic body without being in contact therewith.

In the present invention, the compensation coil may include a solenoid part wound around the bobbin, a first lead-out part positioned between one end of the solenoid part and the first connection pin, and a second lead-out part positioned between the other end of the solenoid part and the second connection pin. The molded member may further include first and second positioning parts for respectively positioning the first and second lead-out parts, and the protective resin may further cover the first positioning part and first lead-out part, as well as the second positioning part and second lead-out part. This can prevent breakage of the first and second positioning parts and disconnection of the compensation coil which are both caused due to an external shock.

In the present invention, the protective resin may be made of a urethane-based material or a silicon-based material. With this configuration, the protective resin can effectively absorb an external shock.

### [Advantageous Effects of the Invention]

As described above, according to the present invention, in a magnetic sensor provided with an external magnetic body for collecting magnetic flux in a magnetism detection element, breakage of a sensor chip and external magnetic body can be prevented.

### [Brief Description of the Drawings]

[FIG. 1]

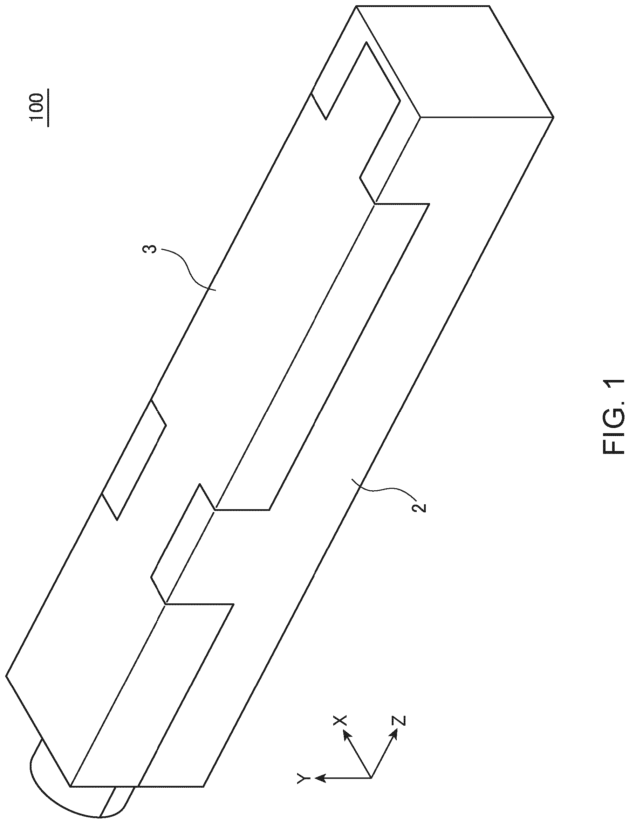

   FIG. 1 is a schematic perspective view illustrating the outer appearance of a magnetic sensor 100 according to an embodiment of the present invention.
[FIG. 2]

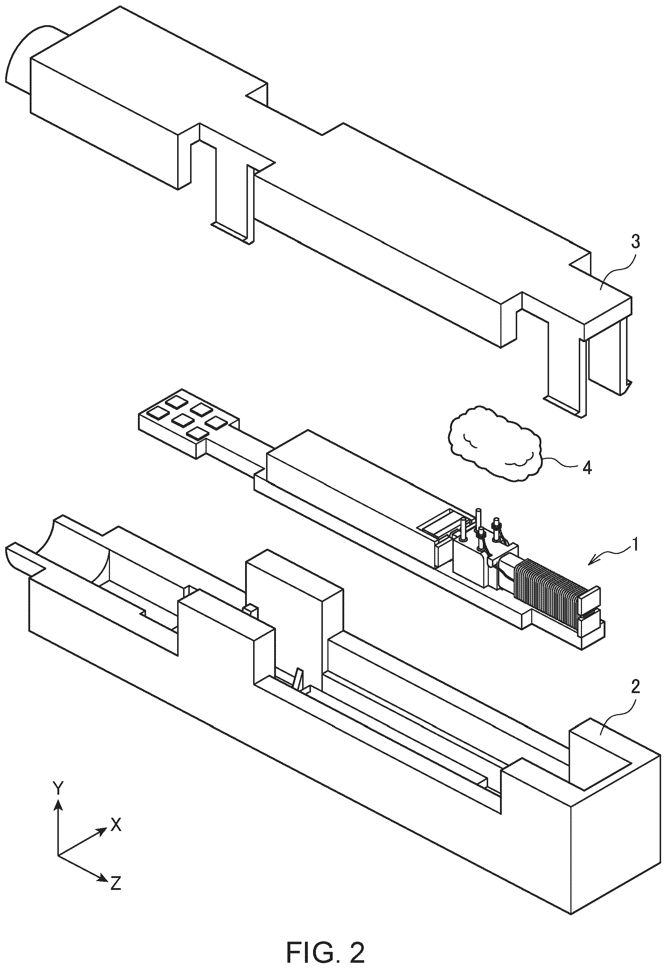

   FIG. 2 is a schematic exploded perspective view of the magnetic sensor 100.
[FIG. 3]

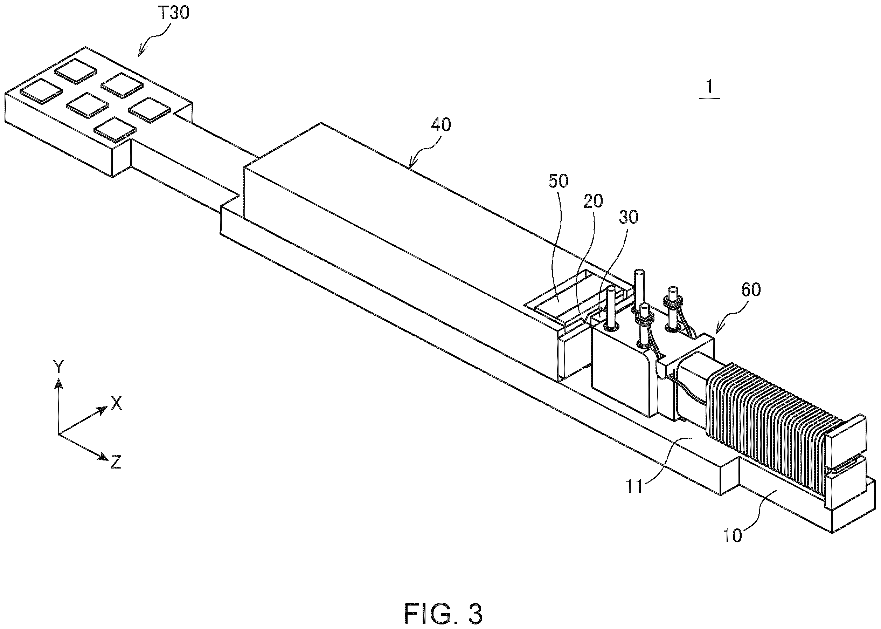

   FIG. 3 is a schematic perspective view illustrating the outer appearance of the magnetic sensor module 1.
[FIG. 4]

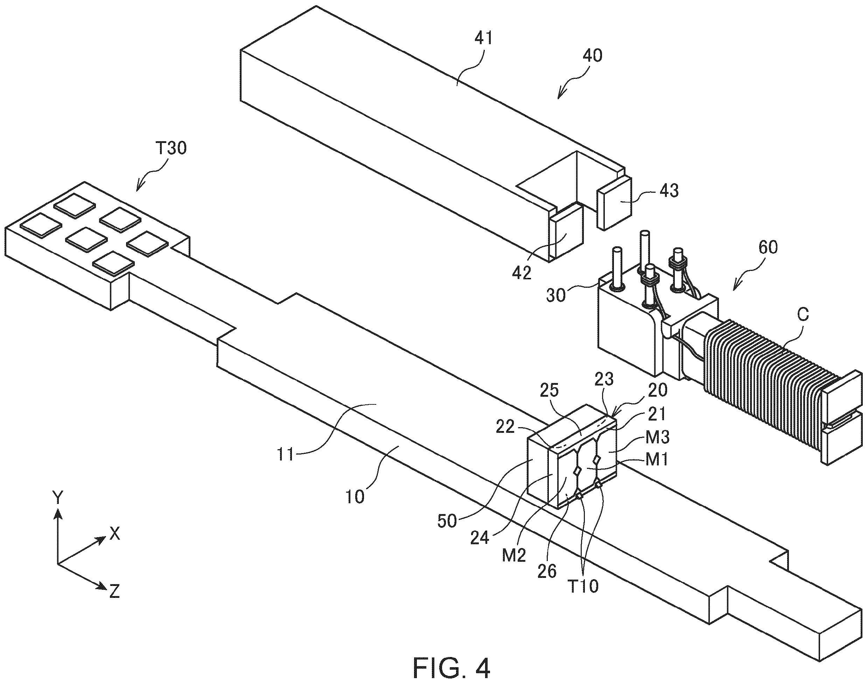

   FIG. 4 is a schematic exploded perspective view of the magnetic sensor module 1.
[FIG. 5]

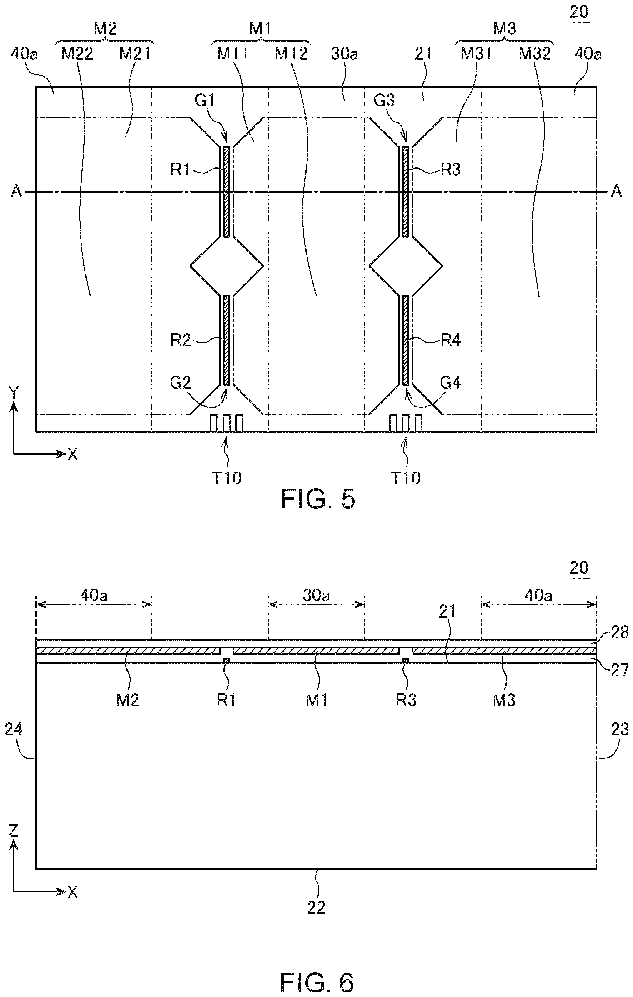

   FIG. 5 is a schematic plan view of the sensor chip 20.
[FIG. 6]
   FIG. 6 is a schematic cross-sectional view taken along the line A-A in FIG. 5.
[FIG. 7]

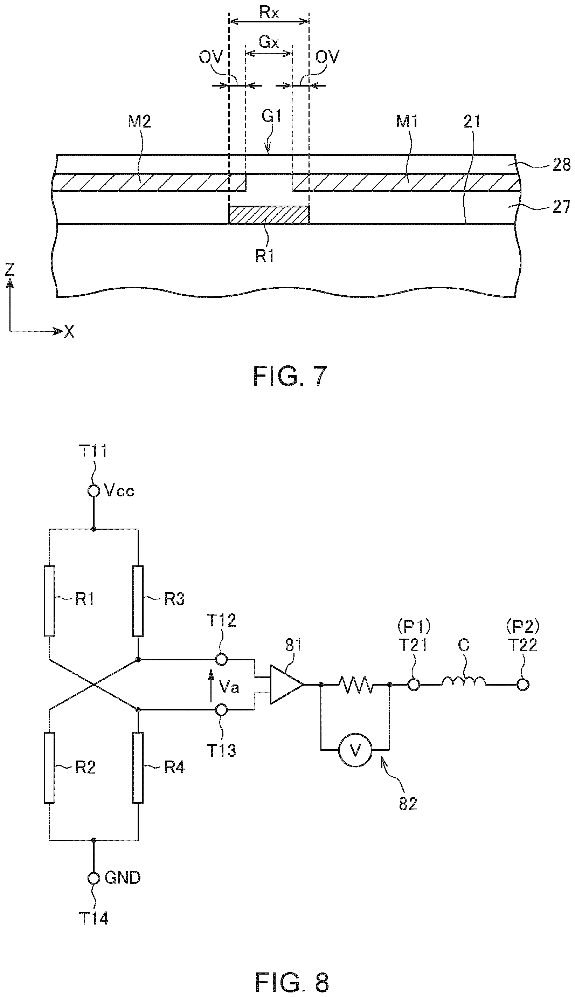

   FIG. 7 is a schematic cross-sectional view for explaining an example in which the magnetic layer and the magnetism detection element overlap.
[FIG. 8]
   FIG. 8 is a circuit diagram for explaining the connection relation between the magnetism detection elements R1 to R4 and the compensation coil C.
[FIG. 9]

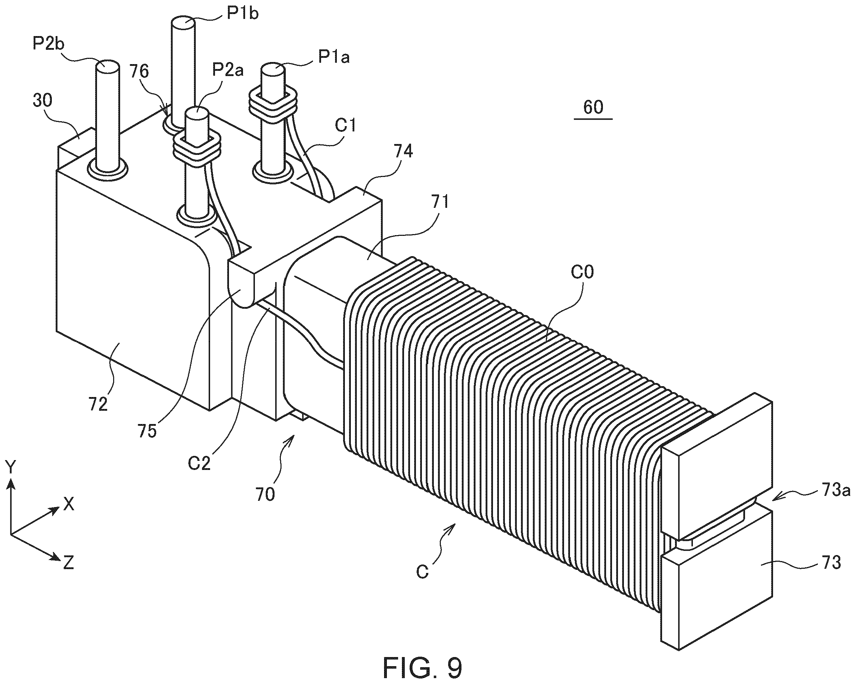

   FIG. 9 is a schematic perspective view for explaining the structure of the magnetism collecting module 60.
[FIG. 10]

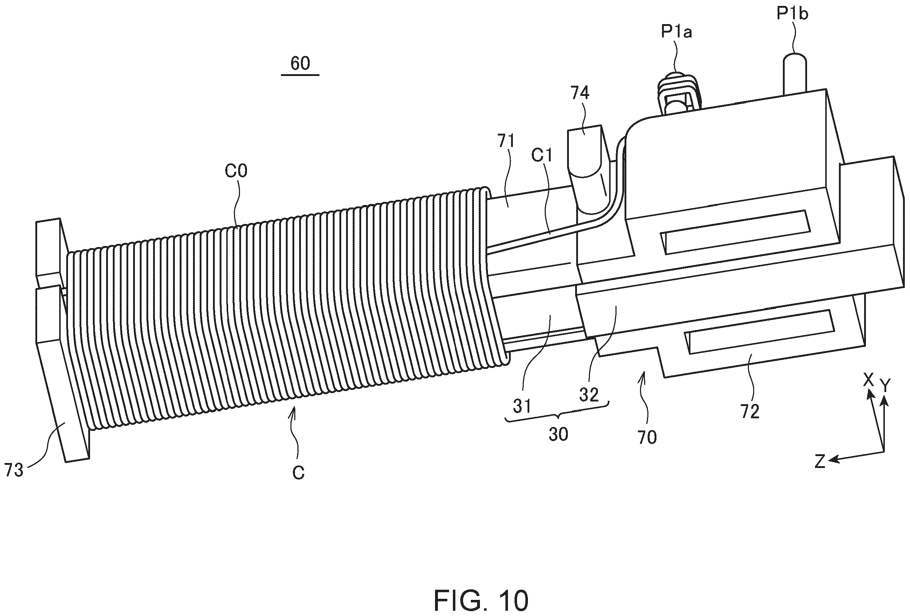

   FIG. 10 is a schematic perspective view for explaining the structure of the magnetism collecting module 60.
[FIG. 11]

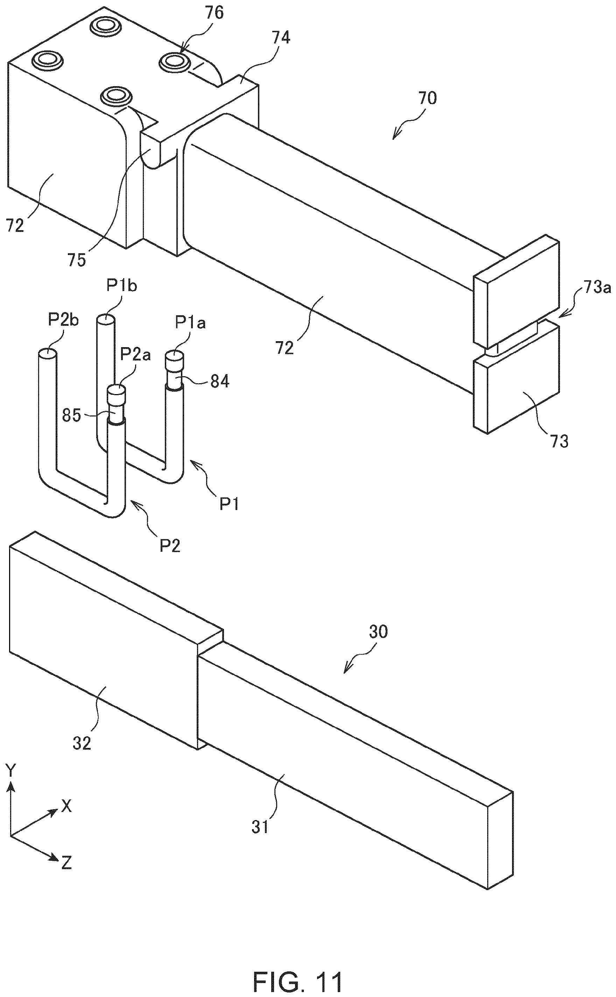

   FIG. 11 is a schematic exploded perspective view of the magnetism collecting module 60 in a state where the compensation coil C is removed.
[FIG. 12]

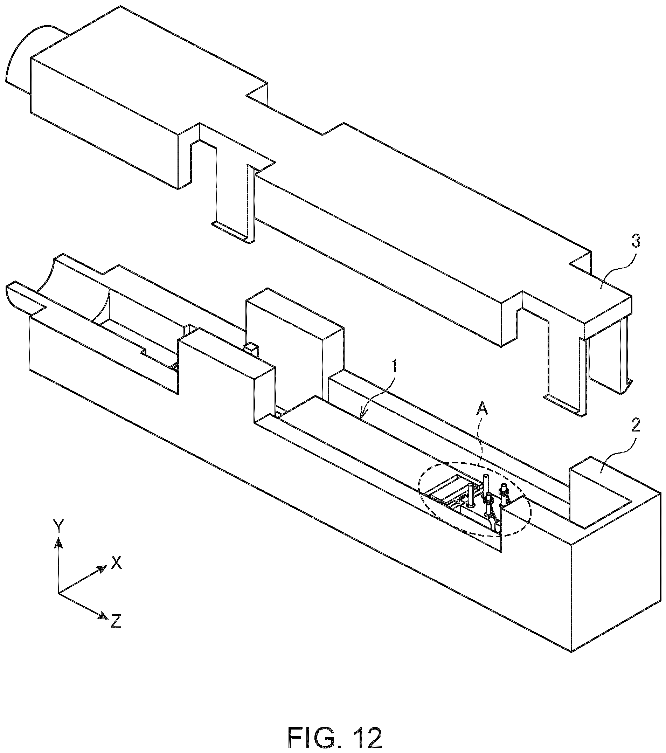

   FIG. 12 is a schematic exploded perspective view for explaining an assembly process of the magnetic sensor 100.
[FIG. 13]

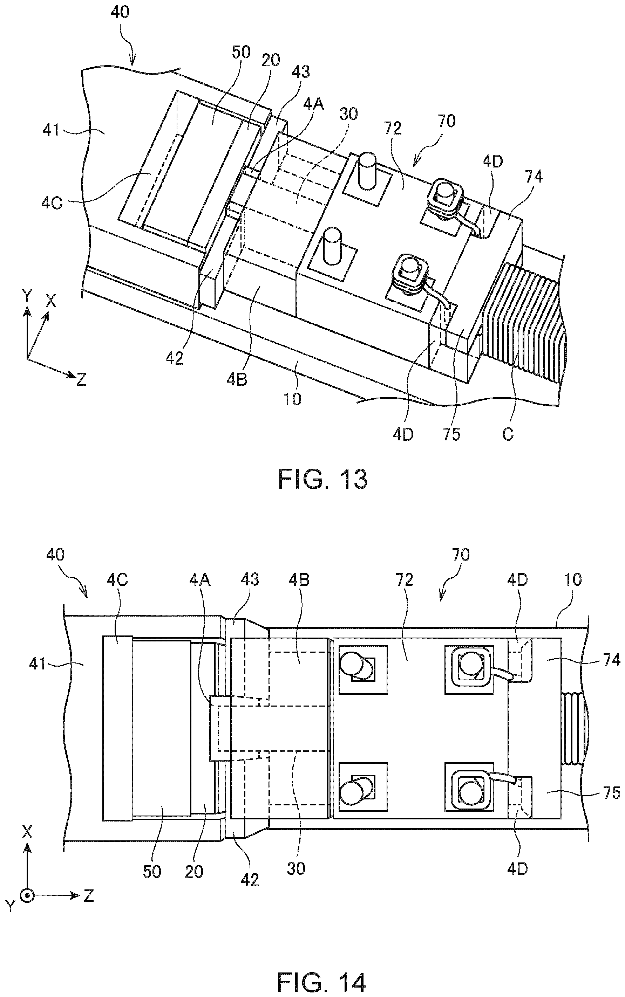

   FIG. 13 is an enlarged view for explaining the application area of the protective resins 4A to 4D.
[FIG. 14]
   FIG. 14 is an enlarged view for explaining the application area of the protective resins 4A to 4D.
[FIG. 15]

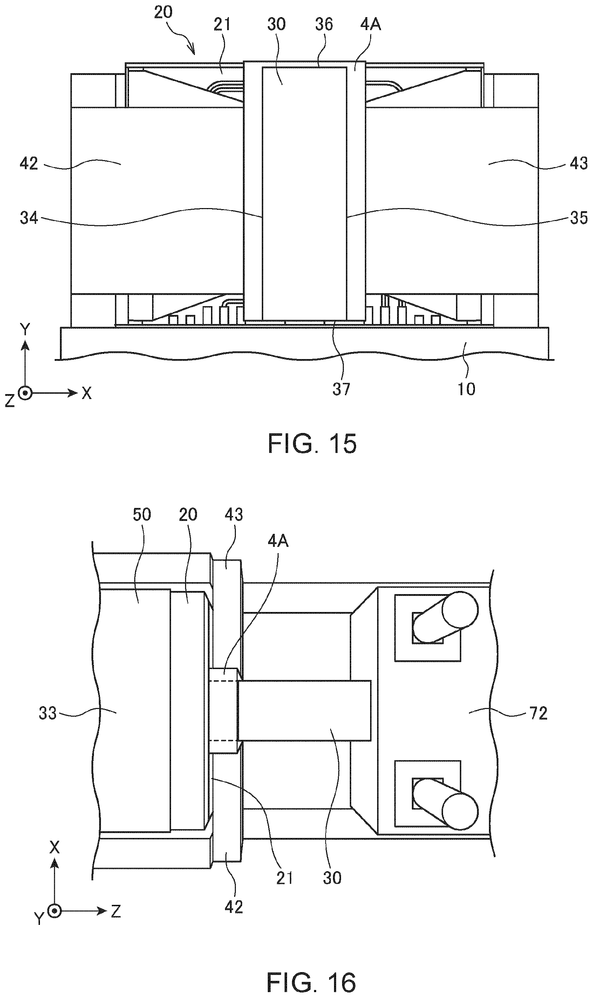

   FIG. 15 is an enlarged view for explaining the application area of the protective resin 4A.
[FIG. 16]
   FIG. 16 is an enlarged view for explaining the application area of the protective resin 4A.

### [Mode for Carrying Out the Invention]

Hereinafter, preferred embodiments of the present invention will be described in detail with reference to the accompanying drawings.

FIG. 1 is a schematic perspective view illustrating the outer appearance of a magnetic sensor 100 according to an embodiment of the present invention. FIG. 2 is a schematic exploded perspective view of the magnetic sensor 100.

As illustrated in FIGS. 1 and 2, the magnetic sensor 100 according to the present embodiment includes a magnetic sensor module 1 as a main body part and lower and upper cases 2 and 3 housing therein the magnetic sensor module 1. The lower and upper cases 2 and 3 are made of a non-magnetic insulating material, such as resin, and fitted to each other in the Y-direction to form an internal space, in which the magnetic sensor module 1 is housed. The main part of the magnetic sensor module 1 is covered with a protective resin 4 made of urethane-based material or silicone-based material. The magnetic sensor 100 has a bar-like body elongated in the Z-direction, and the end portion thereof on the positive Z-direction side constitutes a sensor head. A not-shown wiring connected to the magnetic sensor module 1 is led out from the end potion on the negative Z-direction side.

FIG. 3 is a schematic perspective view illustrating the outer appearance of the magnetic sensor module 1. FIG. 4 is a schematic exploded perspective view of the magnetic sensor module 1.

As illustrated in FIGS. 3 and 4, the magnetic sensor module 1 includes a substrate 10, a sensor chip 20, an external magnetic body 40, and an auxiliary chip 50 which are mounted on a surface 11 constituting the XZ plane of the substrate 10, and a magnetism collecting module 60 including an external magnetic body 30. The sensor chip 20 has an element formation surface 21 and a back surface 22 which constitute the XY plane, side surfaces 23 and 24 constituting the YZ plane, and side surfaces 25 and 26 constituting the XZ plane and is mounted on the substrate 10 such that the side surface 26 faces the surface 11 of the substrate 10. There are formed on the element formation surface 21 of the sensor chip 20, a magnetism detection element (to be described later) and magnetic layers M1 to M3 (to be described later). As described above, in the present embodiment, the surface 11 of the substrate 10 and the element formation surface 21 of the sensor chip 20 are perpendicular to each other; however, they need not be completely perpendicular to each other, but the angle formed therebetween may deviate from the perpendicularity.

The external magnetic bodies 30 and 40 act to collect magnetic flux in the sensor chip 20 and are made of a high-permeability material, such as ferrite. The external magnetic body 30 has a bar-like body elongated in the Z-direction and is positioned at substantially the X-direction center of the element formation surface 21 so as to partly cover the magnetic layer M1. The external magnetic body 40 is positioned on the side opposite to the external magnetic body 30 with respect to the sensor chip 20. The external magnetic body 40 has a bar-like part 41 elongated in the Z-direction and covering the back surface 22 of the sensor chip 20 and overhang parts 42 and 43 protruding in the Z-direction to the element formation surface 21 side from the bar-like part 41 so as to respectively cover the side surfaces 23 and 24 of the sensor chip 20 and extending in the X-direction so as to partly cover the magnetic layers M2 and M3. With this configuration, a magnetic field in the Z-direction is selectively collected, and the collected magnetic field is applied to the sensor chip 20.

The auxiliary chip 50 acts to enhance the strength of the sensor chip 20 and is stuck to the back surface 22 of the sensor chip 20 using an adhesive or the like. The auxiliary chip 50 may be made of the same material as the material of the sensor chip 20. Although not particularly limited, the thickness of the auxiliary chip 50 in the Z-direction is larger than the thickness of the sensor chip 20 in the Z-direction, whereby the mechanical strength of the sensor chip 20 is sufficiently enhanced.

The magnetism collecting module 60 includes a molded member 70 housing the external magnetic body 30 and a compensation coil C wound around the molded member 70. The number of turns of a wire constituting the compensation coil C is not particularly limited and may be set to a value required to generate a target cancelling magnetic field. The molded member 70 is made of a non-magnetic insulating member, such as resin. The structure and role of the molded member 70 will be described later.

FIG. 5 is a schematic plan view of the sensor chip 20, and FIG. 6 is a schematic cross-sectional view taken along the line A-A in FIG. 5.

As illustrated in FIGS. 5 and 6, four magnetism detection elements R1 to R4 are formed on the element formation surface 21 of the sensor chip 20. The magnetism detection elements R1 to R4 are not particularly limited in type as long as they are elements whose electric resistance varies depending on the direction of magnetic flux and may be, for example, an MR element. The fixed magnetization directions of the magnetism detection elements R1 to R4 are the same direction (for example, positive X-direction). The magnetism detection elements R1 to R4 are covered with an insulating layer 27, on the surface of which magnetic layers M1 to M3 made of permalloy are formed. The magnetic layers M1 to M3 are covered with an insulating layer 28. Assume that parts of the respective magnetic layers M1 to M3 that are positioned at one side (upper side in FIG. 5) in the Y-direction are defined as magnetic layers M11, M21, and M31, and parts of the respective magnetic layers M1 to M3 that are positioned at the other side (lower side in FIG. 5) in the Y-direction are defined as magnetic layers M12, M22, and M32. In this case, in a plan view (as viewed in the Z-direction), the magnetism detection element R1 is positioned between the magnetic layers M11 and M21, the magnetism detection element R2 is positioned between the magnetic layers M12 and M22, the magnetism detection element R3 is positioned between the magnetic layers M11 and M31, and the magnetism detection element R4 is positioned between the magnetic layers M12 and M32. With this configuration, magnetic fields passing through respective magnetic gaps G1 to G4 are applied respectively to the magnetism detection elements R1 to R4.

However, in the present invention, the magnetism detection elements R1 to R4 each need not be positioned between two corresponding magnetic layers in a plan view but may each be disposed at least in the vicinity of the magnetic gaps G1 to G4 constituted by two magnetic layers, that is, on a magnetic path formed by the magnetic gaps G1 to G4. Further, the width of each of the magnetic gaps G1 to G4 need not be larger than the width of each of the magnetism detection elements R1 to R4 and may be smaller than the width of each of the magnetism detection elements R1 to R4. In the example illustrated in FIG. 7, a width Gx of the magnetic gap G1 in the X-direction is smaller than a width Rx of the magnetism detection element R1 in the X-direction, and thus the magnetic layers M1 and M2 and the magnetism detection element R1 have an overlap OV in the Z-direction. The positional relation between the magnetic gaps G1 to G4 and the magnetism detection elements R1 to R4 may be that illustrated in FIG. 7.

In FIGS. 5 and 6, the area designated by a reference numeral 30a is an area covered with the external magnetic body 30, and the areas designated by reference numerals 40a are areas covered with the external magnetic body 40. As illustrated in FIGS. 5 and 6, the external magnetic body 30 covers the magnetic layer M1, and the external magnetic body 40 covers the magnetic layers M2 and M3. To efficiently apply a magnetic field collected by the external magnetic body 30 to the magnetism detection elements R1 to R4, the XY end face of the external magnetic body 30 facing the element formation surface 21 preferably directly contacts the insulating layer 28 on the magnetic layer M1 directly or through an adhesive.

FIG. 8 is a circuit diagram for explaining the connection relation between the magnetism detection elements R1 to R4 and the compensation coil C.

As illustrated in FIG. 8, the magnetism detection element R1 is connected between terminal electrodes T11 and T13, the magnetism detection element R2 is connected between terminal electrodes T12 and T14, the magnetism detection element R3 is connected between terminal electrodes T11 and T12, and the magnetism detection element R4 is connected between terminal electrodes T13 and T14. The terminal electrodes T11 to T14 constitute a terminal electrode group T10 illustrated in FIG. 4. The terminal electrode group T10 is provided on the sensor chip 20 and connected to a terminal electrode group T30 illustrated in FIGS. 3 and 4 through a not-shown wiring formed on the substrate 10. The terminal electrode T11 is applied with a power supply potential Vcc, and the terminal electrode T14 is applied with a ground potential GND. Since the magnetism detection elements R1 to R4 have the same fixed magnetization direction, a difference occurs between a resistance change in the magnetism detection elements R1 and R2 which are positioned on one side as viewed from the external magnetic body 30 and a resistance change in the magnetism detection elements R3 and R4 which are positioned on the other side as viewed from the external magnetic body 30. As a result, the magnetism detection elements R1 to R4 constitute a differential bridge circuit, and a change in the electrical resistance of the magnetism detection elements R1 to R4 according to a magnetic flux density appears in the terminal electrodes T12 and T13 as a differential signal Va.

The differential signal Va output from the terminal electrodes T12 and T13 is input to a differential amplifier 81 provided on the substrate 10 or sensor chip 20. An output signal from the differential amplifier 81 is fed back to a terminal electrode T21. As illustrated in FIG. 8, the compensation coil C is connected between the terminal electrode T21 and a terminal electrode T22, whereby the compensation coil C generates a cancelling magnetic field in accordance with the output signal from the differential amplifier 81. The terminal electrodes T21 and T22 are connected respectively to connection pins P1 and P2 retained by the molded member 70. When the differential signal Va output in accordance with a change in the electric resistance of the magnetism detection elements R1 to R4 according to the magnetic flux density of a magnetic field to be detected appears in the terminal electrodes T12 and T13, a corresponding current flows in the compensation coil C to generate a cancelling magnetic field in the reverse direction. This cancels the magnetic field to be detected. Then, a current output from the differential amplifier 81 is current-voltage converted, whereby the strength of the magnetic field to be detected can be detected. By such closed-loop control, it is possible to detect a magnetic field collected through the external magnetic bodies 30 and 40 with high accuracy.

FIGS. 9 and 10 are schematic perspective views for explaining the structure of the magnetism collecting module 60 as viewed from mutually different angles. FIG. 11 is a schematic exploded perspective view of the magnetism collecting module 60 in a state where the compensation coil C is removed.

As illustrated in FIGS. 9 to 11, the magnetism collecting module 60 includes the molded member 70, the external magnetic body 30 fixed to the molded member 70, the compensation coil C, and the connection pins P1 and P2. The molded member 70 is a single member including a bobbin 71, a retaining part 72, a leading end part 73, and a positioning parts 74 and 75. The bobbin 71 houses therein a narrow part 31 of the external magnetic body 30 and has the leading end part 73 at its leading end in the positive Z-direction. The leading end part 73 has a slit 73a extending in the X-direction. The slit 73a is used to fix the position of the wire forming the compensation coil C. The retaining part 72 is positioned on the negative Z-direction side of the bobbin 71, houses therein a wide part 32 of the external magnetic body 30, and retains the connection pins P1 and P2 provided in their corresponding through holes 76. The XY cross section of the narrow part 31 of the external magnetic body 30 is smaller than that of the wide part 32 of the external magnetic body 30.

The connection pins P1 and P2 are each a terminal electrode made of a U-like metal material. The connection pin P1 has protruding parts P1a and P1b protruding in the positive Y-direction from the surface of the retaining part 72, and the connection pin P2 has protruding parts P2a and P2b protruding in the positive Y-direction from the surface of the retaining part 72. The protruding part P1a is a part connected with one end of the compensation coil C, and the protruding part P2a is a part connected with the other end of the compensation coil C. The protruding parts P1a and P2a are arranged in the X-direction and positioned on the negative Z-direction side of the bobbin 71. The protruding parts P1b and P2b are connected respectively with the terminal electrodes T21 and T22 illustrated in FIG. 8 each through a not-shown wiring.

As illustrated in FIG. 10, the XZ bottom surfaces of the bobbin 71 and retaining part 72 are partly opened, through which the external magnetic body 30 is exposed. The XZ bottom surface of the wide part 32 of the external magnetic body 30 protrudes in the negative Y-direction from the retaining part 72. Thus, when the magnetism collecting module 60 is mounted on the substrate 10, the wide part 32 of the external magnetic body 30 is fixed to the surface 11 of the substrate 10. On the other hand, the XZ bottom surface of the narrow part 31 of the external magnetic body 30 does not protrude from the bobbin 71. The XZ bottom surface of the bobbin 71 need not necessarily have the opening; however, forming the opening allows the external magnetic body 30 to be attached to the molded member 70 in the Y-direction.

The compensation coil C is wound around the bobbin 71 with the Z-direction as the winding axis direction. One end of the compensation coil C is connected to the protruding part P1a of the connection pin P1, and the other end thereof is connected to the protruding part P2a of the connection pin P2. The protruding parts P1a and P2a respectively have positioning parts 84 and 85 with locally reduced diameters. The one and the other ends of the compensation coil C are respectively wound around the positioning parts 84 and 85 and soldered thereto. As a result, the Y-direction positions of the one end and the other end of the compensation coil C connected respectively to the protruding parts P1a and P2a are fixed. The positioning parts 84 and 85 are located at positions closer to the leading ends of the respective connection pins P1 and P2 in the positive Y-direction than to the retaining part 72. Thus, the one end and the other end of the compensation coil C are also fixed at positions closer to the leading ends of the connection pins P1 and P2 in the positive Y-direction than to the retaining part 72.

The compensation coil C includes a solenoid part C0 wound around the bobbin 71, a lead-out part C1 positioned between one end of the solenoid part C0 and the connection pin P1, and a lead-out part C2 positioned between the other end of the solenoid part C0 and the connection pin P2. The solenoid part C0 functions as a coil and is wound around the bobbin 71 with the Z-direction as the winding axis direction. The solenoid part C0 is wound around the bobbin 71 such that the Z-direction position of the wire constituting the solenoid part C0 changes for every turn. That is, when the lead-out parts C1 and C2 are set as staring and end points, respectively, the position of the wire constituting the solenoid part C0 shifts in the positive Z-direction for every turn.

As described above, the compensation coil C is wound around the external magnetic body 30 not directly but through the bobbin 71, so that the compensation coil C and external magnetic body 30 do not contact each other, thereby preventing the compensation coil C and external magnetic body 30 from being damaged due to contact therebetween.

The molded member 70 has the positioning parts 74 and 75 positioned between the bobbin 71 and retaining part 72. The positioning part 74 is a protrusion for positioning the lead-out part C1 of the compensation coil C and protrudes in the positive X-direction. The positioning part 75 is a protrusion for positioning the lead-out part C2 of the compensation coil C and protrudes in the negative X-direction. The lead-out parts C1 and C2 extending in the Z-direction respectively pass through the negative Y-direction sides of the positioning parts 74 and 75 to be connected respectively to the connection pins P1 and P2. This restricts the movement of the lead-out parts C1 and C2 in the positive Y-direction.

As described above, in the present embodiment, the external magnetic body 30 and the connection pins P1 and P2 are fixed to the molded member 70, and then winding of the compensation coil C and connection between the connection pins P1 and P2 and the compensation coil C are carried out to produce the magnetism collecting module 60, followed by mounting of the produced magnetism collecting module 60 on the substrate 10, thus allowing the magnetic sensor module 1 to be produced efficiently.

FIG. 12 is a schematic exploded perspective view for explaining an assembly process of the magnetic sensor 100 according to the present embodiment.

As illustrated in FIG. 12, in the assembly process of the magnetic sensor 100, the above-described magnetic sensor module 1 is produced and housed in the lower case 2, followed by application of the protective resin 4 onto the main part of the magnetic sensor module 1. The protective resin 4 is applied at least onto the area A illustrated in FIG. 12. The area A includes the portion where the element formation surface 21 of the sensor chip 20 and the external magnetic body 30 are in proximity to each other. The protective resin 4 acts to alleviate an external shock to prevent breakage of the magnetic sensor module 1 and is made of a resin material excellent in elasticity, such as a urethane-based material or a silicon-based material. After the main part of the magnetic sensor module 1 is thus covered with the protective resin 4, the upper case 3 is fitted to the lower case 2, whereby the magnetic sensor 100 according to the present embodiment is completed.

FIGS. 13 and 14 are each an enlarged view for explaining the application area of the protective resin 4 as viewed from mutually different angles.

As illustrated in FIGS. 13 and 14, the protective resin 4 includes protective resins 4A to 4D. The protective resin 4A is positioned in proximity to the sensor chip 20 at a portion around the external magnetic body 30. As illustrated in FIGS. 15 and 16 which illustrate a state where the protective resins 4B to 4D are removed, the protective resin 4A covers the element formation surface 21 of the sensor chip 20 and the surface of the external magnetic body 30 positioned in the proximity of the sensor chip 20. The surface of the external magnetic body 30 positioned in the proximity of the sensor chip 20 refers to side surfaces 34 to 36 of the external magnetic body 30 at a part of the external magnetic body 40 adjacent in the X-direction to the overhang parts 42 and 43. The side surfaces 34 to 36 constitute the outer peripheral surface of the cross section of the external magnetic body 30 perpendicular to the Z-direction (longitudinal direction), in which the side surfaces 34 and 35 of the external magnetic body 30 constitute the YZ plane, and the side surface 36 of the external magnetic body 30 constitutes the XZ plane. A side surface 37 of the external magnetic body 30 positioned on the side opposite the side surface 36 is stuck to the surface 11 of the substrate 10 through an adhesive or the like, and no gap is produced therebetween, so that the side surface 37 of the external magnetic body 30 need not be covered with the protective resin 4A. The side surfaces 34 and 35 are surfaces connecting the side surfaces 36 and 37. An end face 33 (XY plane) of the external magnetic body 30 positioned at the leading end in the Z-direction (longitudinal direction) and facing the element formation surface 21 is preferably not covered with the protective resin 4A but preferably brought into close contact with the insulating layer 28 positioned on the element formation surface 21 as described above. As described above, the protective resin 4A fills the gap formed between the external magnetic body 30 and the overhang parts 42 and 43 and covers a part of the element formation surface 21.

The protective resin 4B is filled in the gap formed between the retaining part 72 of the molded part 70 and the overhang parts 42 and 43 so as to cover the surface 11 of the substrate 10 and the side surfaces 34 to 36 of the external magnetic body 30. The protective resin 4B may be integrated with the protective resin 4A described above.

The protective resin 4C is provided between the XY plane of the bar-like part 41 of the external magnetic body 40 and the auxiliary chip 50. Thus, the gap formed between the bar-like part 41 of the external magnetic body 40 and the auxiliary chip 50 is filled with the protective resin 4C. When the auxiliary chip 50 is not used, the protective resin 4C is filled in the gap formed between the XY plane of the bar-like part 41 of the external magnetic body 40 and the back surface 22 of the sensor chip 20.

The protective resin 4D is filled in recesses of the molded part 70 formed by the protrusive positioning parts 74 and 75. Thus, not only the positioning parts 74 and 75, but also the lead-out parts C1 and C2 of the compensation coil C that pass respectively through the positioning parts 74 and 75 are covered with the protective resin 4D.

Providing the protective resins 4A to 4D makes the sensor chip 20 and external magnetic bodies 30 and 40 unlikely to be broken even upon application of an external shock. The portion where the sensor chip 20 and external magnetic body 30 are in proximity to each other is most likely to be broken; however, the protective resin 4A is provided so as to cover this portion, thus preventing breakage of the sensor chip 20 and external magnetic body 30 at this portion. Further, the protective resin 4B acts to more strongly protect the external magnetic body 30 and to protect the leading ends of the overhang parts 42 and 43 which are likely to be broken. Further, the protective resin 4C acts to protect the root portions of the overhang parts 42 and 43, and the protective resin 4D acts to prevent disconnection of the lead-out parts C1 and C2 of the compensation coil C.

As described above, in the present embodiment, the main part of the magnetic sensor module 1 is covered with the protective resin 4, thus making it possible to prevent breakage of the magnetic sensor module 1 upon application of an external shock.

While the preferred embodiment of the present disclosure has been described, the present disclosure is not limited to the above embodiment, and various modifications may be made within the scope of the present disclosure, and all such modifications are included in the present disclosure.

### [Reference Signs List]

1 magnetic sensor module
2 lower case
3 upper case
4, 4A-4D protective resin
10 substrate
11 surface of substrate
20 sensor chip
21 element formation surface
22 back surface of sensor chip
23-26 side surface of sensor chip
27, 28 insulating layer
30, 40 external magnetic body
30a, 40a area covered with external magnetic body
31 narrow part
32 wide part
33 end face of external magnetic body
34-37 side surface of external magnetic body
41 bar-like part
42, 43 overhang part
50 auxiliary chip
60 magnetism collecting module
70 molded member
71 bobbin
72 retaining part
73 leading end part
73a slit
74, 75 positioning part
76 through hole
81 differential amplifier
82 detection circuit
84, 85 positioning part
100 magnetic sensor
C compensation coil
C0 solenoid part
C1, C2 lead-out part
G1-G4 magnetic gap
M1-M3, M11, M21, M31, M12, M22, M32 magnetic layer
P1, P2 connection pin
P1a, P1b, P2a, P2b protruding part
R1-R4 magnetism detection element
T10, T30 terminal electrode group
T11-T14, T21, T22 terminal electrode

## Claims

1. A magnetic sensor comprising:
a sensor chip having an element formation surface on which a magnetism detection element is formed;
a first external magnetic body having an end face positioned at a leading end in a longitudinal direction thereof and facing the element formation surface and a plurality of side surfaces constituting outer peripheral surfaces of the cross section thereof perpendicular to the longitudinal direction; and
a protective resin covering at least partially the element formation surface and the plurality of side surfaces of the first external magnetic body.

2. The magnetic sensor as claimed in claim 1, further comprising a substrate on which the sensor chip and first external magnetic body are mounted,
wherein the sensor chip is mounted on the substrate such that the element formation surface thereof is substantially perpendicular to a surface of the substrate,
wherein the plurality of side surfaces of the first external magnetic body include a first side surface facing the substrate, a second side surface positioned on a side opposite the first side surface, and third and fourth side surfaces positioned opposite to each other and connecting the first and second side surfaces, and
wherein the protective resin covers at least partially the element formation surface and second to fourth side surfaces.

3. The magnetic sensor as claimed in claim 1 or 2, further comprising a second external magnetic body having a bar-like part facing a back surface of the sensor chip positioned on a side opposite the element formation surface,
wherein the protective resin is further provided between the back surface of the sensor chip and the bar-like part of the second external magnetic body.

4. The magnetic sensor as claimed in claim 3, further comprising an auxiliary chip stuck to the back surface of the sensor chip,
wherein the protective resin is provided between the auxiliary chip and the bar-like part of the second external magnetic body.

5. The magnetic sensor as claimed in claim 3 or 4,
wherein the second external magnetic body further includes an overhang part protruding from the bar-like part toward the element formation surface and bent so as to cover a part of the element formation surface, and
wherein the protective resin further covers the overhang part.

6. The magnetic sensor as claimed in claim 5, further comprising:
a molded member fixed to the first external magnetic body;
a compensation coil; and
first and second connection pins,
wherein the molded member includes a bobbin and a retaining part which house therein the first external magnetic body,
wherein the retaining part is positioned between the sensor chip and the bobbin,
wherein the compensation coil is wound around the bobbin,
wherein the first and second connection pins are fixed to the retaining part,
wherein one end and other end of the compensation coil are connected respectively to the first and second connection pins, and
wherein the protective resin is embedded between the retaining part and the overhang part.

7. The magnetic sensor as claimed in claim 6,
wherein the compensation coil includes a solenoid part wound around the bobbin, a first lead-out part positioned between one end of the solenoid part and the first connection pin, and a second lead-out part positioned between other end of the solenoid part and the second connection pin,
wherein the molded member further includes first and second positioning parts for respectively positioning the first and second lead-out parts, and
wherein the protective resin further covers the first positioning part and first lead-out part, as well as the second positioning part and second lead-out part.

8. The magnetic sensor as claimed in any one of claims 1 to 7, wherein the protective resin is made of a urethane-based material or a silicon-based material.
